# EUROPEAN PATENT APPLICATION

(11) **EP 4 391 784 A1**
(43) Date of publication of application: **26.06.2024**
(21) Application number: 22216135.8
(22) Date of filing: 22.12.2022
(51) Int. Cl.: H10N 60/01, G06N 10/40, H10N 60/12, H10N 69/00

(54) **TRENCHED ELECTRODE MANUFACTURING PROCESS FOR QUANTUM DEVICE**

(71) Applicant: Imec VZW, 3001 Leuven (BE); Katholieke Universiteit Leuven KU Leuven Research & Development, 3000 Leuven (BE)
(72) Inventor: POTOCNIK, Anton, 3001 Leuven (BE); IVANOV, Tsvetan, 3001 Heverlee (BE); MONGILLO, Massimo, 3010 Kessel-Lo (BE); WAN, Danny, 3000 Leuven (BE); ANANTHAPADMANABHA RAO, Vadiraj Manjunath, 3000 Leuven (BE); PEREZ LOZANO, Daniel, 1030 Schaerbeek (BE)
(74) Representative: Winger

(57) **Abstract**

A method (100) for making a Josephson junction (200) for quantum devices, the method comprising: providing (101) a semiconductor substrate (201); providing (102) a bottom electrode (202) comprising a first metal, by creating (102A) one or more trenches (208) in the semiconductor substrate (201), by filling (102B) the one or more trenches with material comprising the first metal; forming (103) a tunnel barrier (205) by removing (103B) native oxide from the bottom electrode (202), followed by in situ oxidation (103C) of the bottom electrode (202); providing (104) a top electrode (206) such that the Josephson junction is formed by the bottom electrode (202), the tunnel barrier (205), and the top electrode (206).

## Description

### Field of the invention

The invention relates to the field of Josephson junctions for quantum devices. More specifically it relates to a method for making a Josephson junction.

### Background of the invention

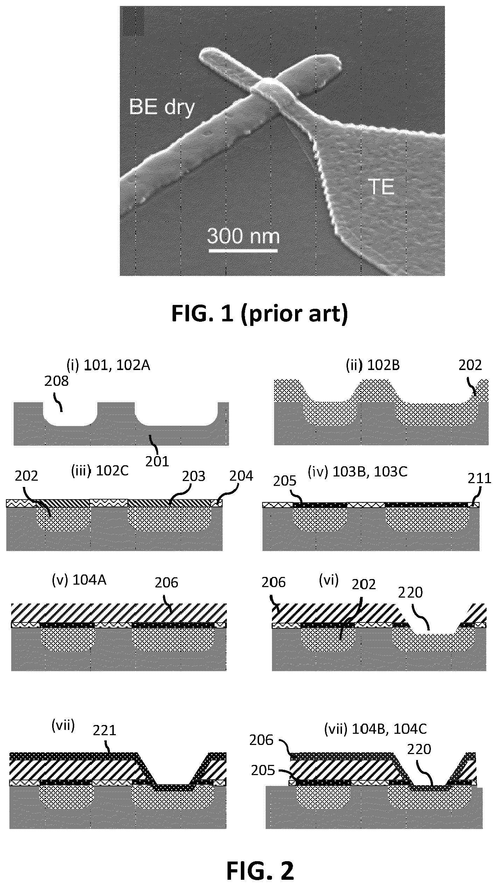

Superconducting quantum computing technology is primarily based on smallscale university laboratory fabrication processes, where only highly specialized process flows based on shadow evaporation and lift-off yield state-of-the-art performance (coherence time) of superconducting qubit. FIG. 1 shows a SEM image of a prior art Josephson junction, which is a critical part of the superconducting qubit. The top electrode (TE) and the bottom electrode (BE) are made of superconducting Al and are placed on a high-resistivity Si substrate. All visible surfaces have native oxides which lead to microwave loss. The success of laboratory process resulting in high device performance is the ability to preserve low defectivity and low contamination of all critical interfaces: metal/air, metal/substrate, substrate/air as well as metal-oxide-metal in Josephson junctions (AI/AIOx/AI, with 2-3 nm thin impurity-free AlOₓ barrier). In the state-of-the-art laboratory-made superconducting qubit devices, which are made out of a planar capacitor and a Josephson junction, the performance is still limited by microwave loss in thin native oxides dominated by the metal-air interfaces, followed by losses at the substrate-air interfaces and lastly by substrate-metal interfaces.

However, laboratory processes yield devices with high variability, which is today limiting the scaling of quantum devices. There is therefore a need for a process flow which allows to reduce the variability of the devices and which is preferably fully compatible with the industrial nano-fabrication technology.

### Summary of the invention

It is an object of embodiments of the present invention to provide a good method for making a Josephson junction for quantum devices.

The above objective is accomplished by a method and device according to the present invention.

Embodiments of the present invention relate to a method for making a Josephson junction for a quantum device. The method comprises providing a semiconductor substrate, providing a bottom electrode embedded in the semiconductor substrate, and providing a top electrode which overlaps at least part of the tunnel barrier and bottom electrode.

Providing the top electrode is done by forming one or more trenches in the semiconductor substrate, and by filling the one or more trenches with material comprising a first metal.

Forming the tunnel barrier on the embedded bottom electrode is done by removing native oxide from the bottom electrode, followed by in situ oxidation of the bottom electrode.

Providing the top electrode is done by providing a second layer comprising a second metal on the tunnel barrier, and by patterning the second layer such that the Josephson junction is formed by the bottom electrode, the tunnel barrier, and the top electrode.

In embodiments of the present invention the one or more trenches are formed such that they have a depth between 50 and 200 nm.

In embodiments of the present invention the method comprises cleaning the surface of the semiconductor substrate before filling the one or more trenches.

In embodiments of the present invention forming a tunnel barrier further comprises cleaning the surface of the bottom electrode and of the semiconductor substrate before removing native oxide from the bottom electrode.

In embodiments of the present invention an upper part of the bottom electrode is removed when patterning the second layer.

In embodiments of the present invention the native oxide is removed by ion beam milling.

In embodiments of the present invention the step of providing a semiconductor substrate comprises providing a silicon substrate.

In embodiments of the present invention the provided semiconductor substrate has a resistivity of at least 1kOhm.cm.

In embodiments of the present invention the first metal is Al.

In embodiments of the present invention filling the one or more trenches, implies filling the one or more trenches with a stack of superconducting materials of which the top material is Al.

In embodiments of the present invention the second metal is Al, or Nb, or alpha-Ta, or NbN, or NbTiN, or TiN, or Mo, or Re.

In embodiments of the present invention the method further comprises, after patterning the second layer, exposing the semiconductor substrate, the bottom electrode and the top electrode to a passivating gas agent.

In embodiments of the present invention the method further comprises providing a via through the top electrode and the tunnel barrier and filling the via with a metal for shorting a spurious Josephson junction.

Embodiments of the present invention also relate to a method for making a qubit. The method comprises making a Josephson junction in accordance with embodiments of the present invention and providing a capacitor in parallel with the Josephson junction.

In embodiments of the present invention the capacitor in parallel with the Josephson junction is made from the material in the trenches such that the bottom electrode comprises two plates which are separated by air and the underlying semiconductor substrate.

In embodiments of the present invention the method comprises depositing and patterning a protection layer everywhere except around the Josephson junction, wherein depositing and patterning of the protection layer is done after filling the one or more trenches and before removing the native oxide.

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

### Brief description of the drawings

FIG. 1 shows a SEM image of a prior art Josephson junction.
FIG. 2 shows schematic drawings of intermediate stacks obtained when executing a method in accordance with embodiments of the present invention.
FIG. 3 shows a flow chart of an exemplary method in accordance with embodiments of the present invention.
FIG. 4 shows a schematic drawing of a top electrode which overlaps with a planarized bottom electrode which is embedded in the semiconductor substrate, in accordance with embodiments of the present invention.
FIG. 5 shows a 3D schematic drawing of a stack obtained using a method in accordance with embodiments of the present invention.
FIG. 6 shows the top view of a qubit made using a method in accordance with embodiments of the present invention.
FIG. 7 shows the cross-section along the vertical arrow in FIG. 6.
FIG. 8 shows the top view of a schematic drawing of a Josephson junction connected to a planar capacitor and wherein a spurious junction is shorted by a via in accordance with embodiments of the present invention.

Any reference signs in the claims shall not be construed as limiting the scope. In the different drawings, the same reference signs refer to the same or analogous elements.

### Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

The terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

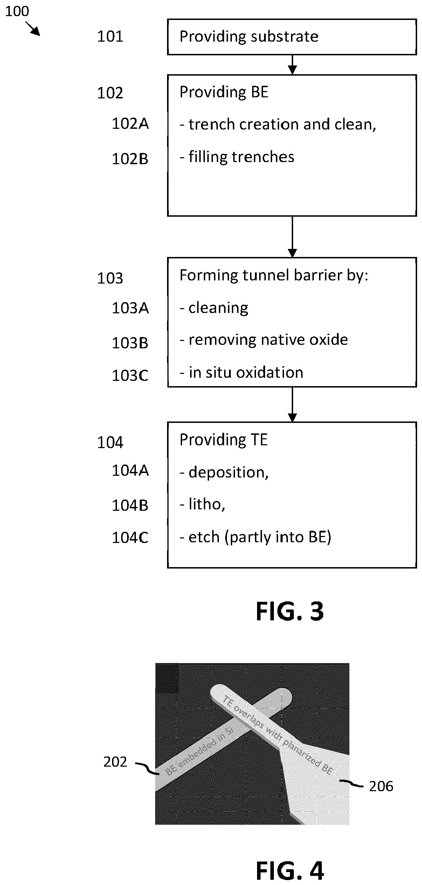

Embodiments of the present invention relate to a method for making a Josephson Junction for a quantum device. The method for creating the overlap Josephson junction comprises 101 providing a semiconductor substrate, providing 102 a bottom electrode, forming 103 a tunnel barrier layer and providing 104 a top electrode. These steps are shown in the flow chart in FIG. 3 of an exemplary method in accordance with embodiments of the present invention.

First a semiconductor substrate 201 is provided 101. This may be a crystalline substrate such as a silicon, or sapphire substrate. In embodiments of the present invention also other substrates such as for example a glass substrate may be used. In embodiments of the present invention the semiconductor substrate may be cleaned using a wet etch (e.g. with hydrofluoric acid). Thereby native oxide on the semiconductor substrate may be removed.

Providing 102 the bottom electrode 202 comprises:
- Forming 102A one or more trenches 208 in the semiconductor substrate 201; This may for example be achieved by providing and patterning a first lithography stack, and etching the semiconductor substrate;
- Filling 102B the one or more trenches 208 with a material comprising the first metal. This may be achieved by depositing a first layer comprising a first metal on the semiconductor substrate such that the one or more trenches are filled with the first metal and by removing any excess material from the semiconductor substrate such that the first metal is only present in the trenches (e.g. by polishing the first layer up to the semiconductor substrate surface to obtain the bottom electrode in the one or more trenches), similar to the Damascene process.

Forming 103 the tunnel barrier 205 on the bottom electrode 202 comprises:
- Removing 103B native oxide from the bottom electrode 202 (e.g. by ion beam-milling) followed by in situ oxidation 103C of the bottom electrode. The native oxide which is removed in this step was naturally formed on the surface of the first metal by oxidation when exposing the first metal to air.

Providing 104 the top electrode 206 such that it at least partly overlaps at least part of the tunnel barrier and bottom electrode, comprises:
- Depositing 104A a second layer comprising a second metal on the tunnel barrier; In embodiments of the present invention the second layer may be deposited in situ on top of the oxidized bottom electrode. Doing the in situ deposition (i.e. in the same chamber as where the tunnel barrier is grown) allows to do the deposition breaking a vacuum in the chamber or without exposure to air.
- Patterning the second layer such that the Josephson Junction is formed by the bottom electrode 202, the tunnel barrier 205, and the top electrode 206. Patterning the second layer may be achieved by providing and patterning 104B a second lithography stack, and etching 104C the second layer.

In embodiments of the present invention the first metal and the second metal are superconducting.

It is a particular advantage of embodiments of the present invention that lossy metal-air interfaces can be reduced by embedding the superconducting electrodes in trenches in the semiconductor substrate. It is an advantage of embodiments of the present invention that the linewidth of the Josephson's junction can be better controlled by reducing the sidewall roughness. It is, moreover, an advantage of embodiments of the present invention that the barrier thickness variability can be reduced, thereby reducing the barrier thickness variability.

It is, moreover, an advantage of embodiments of the present invention that no metal etch step of the first metal is required. This reduces the chance of lossy processing residues to be formed and get trapped at the sidewall and with that improve device performance.

It is an advantage of embodiments of the present invention that they are compatible with large-scale manufacturing techniques.

In embodiments of the present invention the one or more trenches are formed 102A such that they have a depth between 30 and 200 nm, for example between 50 and 200 nm. The minimal dimension is set by the superconducting coherence length and it should not be less than 30 nm for Al. There is no upper limit. For easing processing requirement the depths may be set between 50-200 nm. The minimal width may for example be 100nm depending on the lithography process. There is no upper limit to the width, some structures are hundreds of µm wide/long such as the planar capacitor however the Josephson junction leads are between 80-300nm wide.

Where in embodiments of the present invention reference is made to in situ oxidation reference is made to oxidation in the same chamber as where the native oxide is removed from the bottom electrode. It is essential that the oxide tunnel barrier 205 between the bottom electrode and the top electrode is obtained by in situ oxidation. Thus a thinner layer can be obtained than the native oxide which is formed from native oxidation of the first metal of the bottom electrode after vacuum break (which may be removed by ion beam-milling). The thickness of the barrier layer should be small enough such that a functioning Josephson Junction is obtained. Too much or too little oxidation would make the Josephson Junction unusable or simply open/shortened.

An AlOₓ barrier layer, obtained after the in situ oxidation of the bottom electrode, may for example have a thickness between 1 and 3 nm, for example between 2 and 3 nm. In embodiments of the present invention an overlap junction area is formed by the top electrode and the bottom electrode with in between both the tunnel barrier. The overlap junction area, in case of an AlOₓ barrier layer, may for example be between 0.01 and 0.1 µm².

In embodiments of the present invention ion beam milling (e.g. Ar-milling) may be used to remove the native oxide from the bottom electrode. The native oxide is the oxide formed from the first metal of the bottom electrode whenever the first metal of the bottom electrode is exposed to air. For example when forming an Al-based bottom electrode also a thin layer of native AlOₓ is formed from the top surface of the Al-based bottom electrode as soon as the Al-based bottom electrode is exposed to air. This native oxide should be removed because otherwise the barrier would be too thick. Removing the native oxide may be combined with plasma treatment for an in situ oxidation. Ion beam milling may also remove surface residues (e.g. CMP residues). These may for example be present on the bottom electrode and on the semiconductor substrate.

In embodiments of the present invention forming 103 a tunnel barrier comprises cleaning 103A the surface of the bottom electrode 202 and of the semiconductor substrate 201 before removing 103B native oxide from the bottom electrode 202. Thereby any material, different from material of the semiconductor substrate 201 and different from material of the bottom electrode 202, is removed from the bottom electrode and from the semiconductor substrate. The native oxide may be removed by ion beam-milling.

While ion beam-milling is typically done locally at the location of the Josephson Junction, and the remaining part of the stack is protected by a resist, in embodiments of the present invention any material different from material of the semiconductor substrate 201 and different from material of the bottom electrode 202 is removed before ion beam-milling. Ion beam-milling is known to detriment interfaces. Therefore, in the prior art ion beam-milling is not done everywhere, but a window is opened locally where the Josephson junction is to be formed and the ion beam-milling is done only within this window to protect the rest of the structure against the ion beam-milling.

Where in embodiments of the present invention reference is made to a lithography stack, reference is made to a lithography stack of one or more layers. The lithography stack at least comprises a photoresist material. The photoresist material may for example be PMMA. The lithography stack typically comprises different layers on the layer to be patterned. Typically a hardmask material is deposited on the layer to be patterned (e.g. SoC/SoG) and the photoresist is present on the hardmask. The lithography stack may for example be a SoC/SoG/resist material stack.

In embodiments of the present invention any remaining material from a possible lithography stack (e.g. a lithography stack for forming the trenches in the semiconductor substrate), is removed before filling the one or more trenches with the material comprising the first metal. In case the first lithography stack comprises a stack of different materials the complete stack of materials is removed.

In embodiments of the present invention removing the native oxide on the first metal is achieved by ion beam milling such as by Ar-milling.

This removal of the native oxide is followed by in situ oxidation of the bottom electrode, which means that the step of removing the native oxide and the step of in situ oxidation is done in the same chamber without exposing the wafer to air between any of these process steps. In embodiments of the present invention the in situ oxidation may be achieved with oxygen plasma. The latter having the advantage of faster oxide growth. The in situ oxidation may for example be achieved by exposing the bottom electrode to O₂ gas in a vacuum chamber. This may be achieved without temperature increase. The O₂ concentration may for example be between 0.1 mbar and 1 mbar of O2 at constant pressure. This flux is also referred to as dynamic oxidation. It may for example be applied for ½ hour to 1 hour. The invention is not limited to these examples.

In embodiments of the present invention providing 104 the top electrode comprises: depositing 104A the second metal layer 206 on the oxide layer 205 after controlled oxidation of the bottom electrode 202, providing a second lithography stack for etching the second metal layer to form the top electrode 206, and removing the second lithography stack. When etching the second metal layer, the underlying oxide layer 205 is exposed.

Etching the second metal layer may be done either wet or dry etching. In case of a Si substrate wet etch processes have the advantage that they leave the top surface of the semiconductor substrate intact. Dry etch processes, on the other hand, provide better control of the junction dimension and reproducibility. Wet etching may for example be based on TMAH. Dry etching may for example be CI-based. The etching may be subtractive etching.

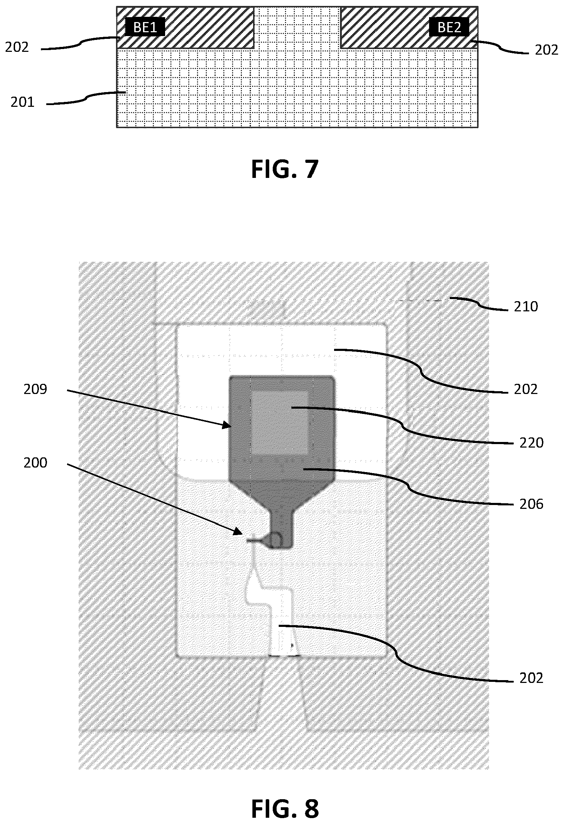

In embodiments of the present invention a spurious Josephson junction (also referred to as "stray junction" may be formed when connecting the desired Josephson junction back to the bottom electrode. This is illustrated in FIG. 8 which shows the bottom electrode 202, top electrode 206, Josephson junction 200, spurious Josephson junction 209, via 220, and the protection layer 210. The inventors have found a method which allows to cancel this spurious Josephson junction without having to make it excessively big. This will be discussed when discussing FIG. 2.

In embodiments of the present invention the exposed oxide layer 205 is removed thereby exposing the underlying bottom electrode 202. In embodiments of the present invention thereafter an upper part of the exposed bottom electrode is removed. It is an advantage of embodiments of the present invention that modifications in the bottom electrode are removed by removing an upper part of the bottom electrode. These modifications in the bottom electrode may for example be caused by the ion beam-milling (e.g. Ar-milling). These modifications lead to losses. By removing an upper part of the bottom electrode surface residues and surface damages are reduced. In embodiments of the present invention removal of the upper part of the bottom electrode is done by over-etching of the top electrode into the bottom electrode. In embodiments of the present invention surface residues and surface damages may also be removed from the semiconductor substrate by over-etching in the semiconductor substrate. As typically the top electrode represents less than 1% of the entire device area, removing an upper part of the bottom electrode is advantageous for increasing the qubit performance and for decreasing the device variation caused by surface defects leading to higher stability of qubits.

This may be done when etching the second layer. This may be achieved by over-etching into the bottom electrode when etching the second metal layer. When patterning the second layer, also part of the tunnel barrier may be removed.

In embodiments of the present invention the first layer and the second layer may for example have a thickness between 50 and 200 nm. The first layer and second layer may for example be deposited by sputtering.

In embodiments of the present invention the first metal is Al. Al forms a single self-limiting thin oxide layer, which is not very lossy (with a microwave loss tangent at mK temperatures of 10^-3), and can be removed by the subsequent ion beam-milling (e.g. Ar milling) process. The ion beam-milling process is followed by in situ oxidation of the bottom electrode. In that case the tunnel barrier 205 is an AlOₓ layer.

In embodiments of the present invention combinations of metals may be used. Providing the bottom electrode may comprise filling the one or more trenches with a stack of superconducting materials of which the top material is Al. The stack may be obtained layer per layer wherein a layer until the trench is filled. Each time a layer of a superconducting material is deposited and subsequently any excess material is removed from the semiconductor substrate (e.g. by CMP and surface clean). The last layer is a thin Al layer. The thickness of the Al layer before barrier oxidation may for example be at least 1 nm, or even at least 2 nm. The oxidation may be such that all Al of the thin Al layer is oxidized. The first layer may for example comprise an additional layer of Nb, or alpha-Ta, or NbN, or NbTiN, or TiN, or Mo, or Re and an Al layer of 1-5 nm deposited on the additional layer. In embodiments of the present invention the second layer may comprise Al, or Nb, or alpha-Ta, or NbN, or NbTiN, or TiN, or Mo, or Re.

In embodiments of the present invention a semiconductor substrate (e.g. a Sisubstrate) is provided which has a resistivity of at least 1 kOhm.cm, the resistivity may even be at least 3 kOhm.cm. The advantage thereof being that high resistance wafers have lower microwave losses. Thus, an improved qubit coherence/performance can be obtained for qubits comprising a Josephson junction in accordance with embodiments of the present invention. The inventors have shown that 3 kOhm.cm does not limit qubit performance up to a Q-factor of 10M. By increasing the semiconductor substrate resistance the performance of the qubit can be increased. Care should be taken, however, because by increasing the semiconductor substrate resistance also the brittleness of the semiconductor substrate increases.

FIG. 2 shows schematic drawings of intermediate stacks obtained when executing a method in accordance with embodiments of the present invention.

Stack (i) is obtained after providing 101 the semiconductor substrate 201 (which in this case is a silicon substrate), after trench creation 102A and after precleaning the semiconductor substrate 201 (this may for example be done by HF cleaning). By precleaning it is assured that the trench is absent of any impurities including the native SiOₓ. This can be achieved by an HF clean and metal deposition in a time critical loop. Preferably the trench has a smooth surface, which means having a low surface roughness. Preferably it has a rounded substrate-metal bottom corner and a right (90deg) substrate-metal-air corner angle.

Stack (ii) is obtained after depositing 102B a first layer 202 comprising a first metal on the semiconductor substrate 201, such that the one or more trenches are filled by the first metal. The layer may be deposited by conformal superconductor thin film deposition (e.g. with a thickness between 50 and 200nm). Evaporation, sputtering, ALD or similar techniques can be used for the deposition. Here Al is the favorable candidate since it can form a low loss Josephson junction (AI/AIOx/AI) however, also other superconducting films can be used such as Ta, Nb, NbN, NbTiN, TiN, etc. Conformality of the deposition is critical to ensure a clean and smooth substrate-metal interface. Using seed layers before metal deposition such as nitrides could improve conformality and enable selective metal growth.

Stack (iii) is obtained after filling 102C the trenches with the first metal. These may be achieved by providing a first layer 202 comprising the first metal and by polishing up to the semiconductor substrate surface. Stack (iii) also shows a native oxide 203 on the metal in the trenches and a native oxide 204 on the semiconductor substrate. Polishing may for example be chemical mechanical polishing (CMP). This step is critical to ensure very low surface roughness of the metal-air interface. Care must be taken not to introduce impurities deep into the metal and not to chirp-off metal at the corners which could increase line-edge roughness. For that aspect the proposed trench profile would perform best. After the CMP a cleaning step may be added to remove introduced impurities either wet or dry. At this fabrication point devices could be already used for high-quality resonators or other devices not requiring Josephson junctions.

Stack (iv) is obtained after removing 103B the native oxide 203 from the bottom electrode 202 followed by in situ oxidation 103C of the bottom electrode to obtain the tunnel barrier 205 (in this example also an oxide 211 is formed on the semiconductor substrate). Removing the native oxide may for example be done by Ar-milling. The insitu oxidation is done in the same chamber as where the native oxide is removed from the bottom electrode. This may be in the metal deposition tool. In embodiments of the present invention the Ar-milling conditions may be optimized to compensate for different removal (etch) rates between metal and semiconductor substrate in order to avoid or minimize substrate-metal step (topology) formation.

Stack (v) is obtained after providing 104A the second layer comprising the second metal. A native oxide may be formed on the second layer 206. The second layer can be deposited using any known technique as mentioned above (preferred is sputtering) and with any superconducting material (Al is preferred). At this point a via can be formed to short the stray junction using a patterning step.

Stack (vi) is obtained after forming a via 220 through the top electrode and the tunnel barrier using a patterning step, etching step, and after removing native oxides using ion beam-milling.

Stack (vii) is obtained after subsequently providing a metal layer 221 in the via. This may for example be an Al layer. As is the case in this example, providing the via may be done before etching of the top electrode. It is thereby advantageous that the junction is protected against additional processing that could lead to additional surface defects and residues. The steps for obtaining stacks (vi) and (vii) could be omitted if the spurious junction is made large, but additional two level systems (TLS) defects residing in the spurious junction will limit the performance of the qubit.

Stack (viii) is obtained after providing and patterning 104B a second lithography stack on the second layer 206 and after etching 104C the second layer to obtain the top electrode 206. The etching may be done such that an upper part of the bottom electrode and/or of the semiconductor substrate is removed during the etching step 104C. In this step also part of the tunnel barrier may be removed during the etching. Preferably this is done carefully to minimize processing residues which could lead to microwave losses as well as to optimize the etch not to introduce notable recess between the bottom electrode and the semiconductor substrate.

FIG. 4 shows a schematic drawing of a top electrode 206 which overlaps with a planarized bottom electrode 202 which is embedded in the semiconductor substrate.

In embodiments of the present invention a surface of a stack which is obtained after etching the second layer is exposed to a passivating agent. It is an advantage of embodiments of the present invention that lower surface dielectric loss is obtained by passivating the surface of the stack. Passivating using fluorine or nitrogen or other halogen chemistry should be done after etching the second layer for forming the top electrode. It should be done before venting the vacuum chamber. Thereby the surface is passivated and the formation of lossy oxide when venting the vacuum chamber is prevented. In case plasma is used for stripping of the first lithography stack the passivation can be applied after applying oxygen plasma in the vacuum chamber and before venting.

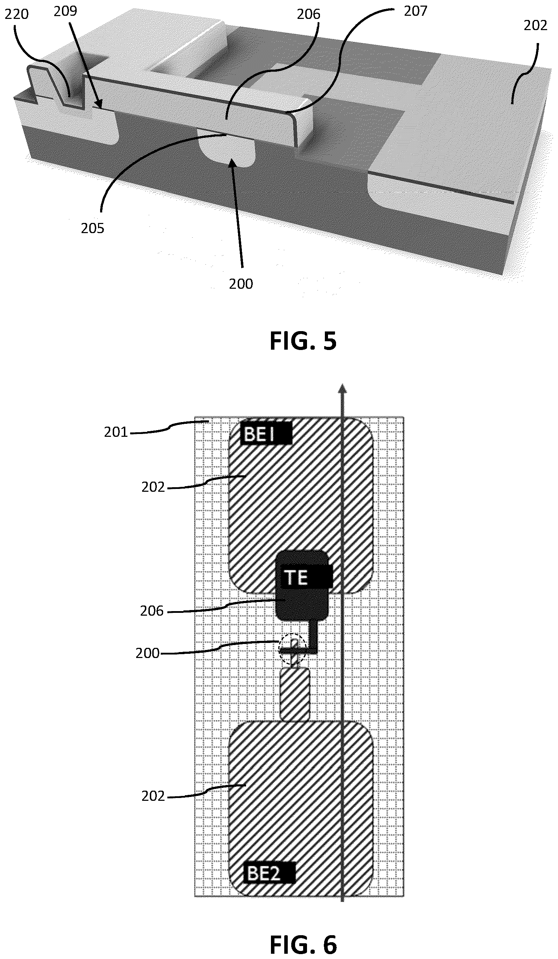

A 3D schematic drawing of a stack obtained using a method in accordance with embodiments of the present invention is shown in FIG. 5. In this drawing a Josephson junction 200 and a spurious Josephson junction 209 are shown. Both are comprising a top electrode 206 which overlaps with a bottom electrode 202 with in between both a tunnel barrier 205. A native oxide 207 is present on the top electrode 206. The spurious Josephson junction is unwanted and should therefore be avoided. This is achieved by providing the via 220 and by providing a metal in the via.

To minimize loss from this spurious Josephson junction in embodiments of the present invention the spurious Josephson junction is cancelled by forming a via 220 through the second layer 206 and the tunnel barrier 205 and the via 220 is filled with a metal 221 for shorting a spurious Josephson junction. It is, thereby, advantageous that spurious junctions can be avoided by providing the via and filling it with a metal.

A method according to embodiments of the present invention may be used for producing a qubit. Such a method comprises making a Josephson junction in accordance with embodiments of the present invention and making a capacitor in parallel with the Josephson junction. By doing so a superconducting transmon qubit may be obtained. Such a qubit is essentially an LC circuit where C is the planar capacitor and L is the Josephson junction. Alternative superconducting qubit types may also be obtained. These may for example comprises a plurality of Josephson junctions in parallel with a single planar capacitor. A non-exhaustive list is for example: Fluxmon qubit, Phase qubit, C-shunted Flux qubit.

It is an advantage of embodiments of the present invention that parameter variation of qubit devices or other quantum devices can be reduced by reducing surface and line-edge roughness using the trenched electrode approach. Especially the barrier thickness variation of the most critical element - the Josephson Junction, can be reduced.

In embodiments of the present invention microwave losses at the metalsubstrate interface are reduced by shaping the trench profile (and hence the profile of the bottom electrode) in a way to minimize the electric field strength at the metal corners.

In embodiments of the present invention the capacitor in parallel with the Josephson junction is made from the first layer such that the bottom electrode comprises a first (BE1) and a second (BE2) conductive plate which are separated by air and the underlying semiconductor substrate. The first (BE1) and the second (BE2) conductive plate are made from the first layer. An example thereof is shown in FIG. 6 and FIG. 7. FIG. 6 shows the top view of a qubit made using a method in accordance with embodiments of the present invention and FIG. 7 shows the cross-section along the vertical arrow in FIG. 6. The top view shows the Josephson junction 200 and shows that the bottom electrode 202 comprises two plates.

It is thereby an advantage of embodiments of the present invention that the bottom electrode of the Josephson junction and the first electrode of the capacitor of the qubit are formed from the same metal layer. This minimizes lossy interfaces between the junction bottom electrode and the resonator/capacitor layer.

In embodiments of the present invention the bottom electrode may encompass the bottom electrode part of one or more Josephson junctions, and different other structures on a device such as waveguides, resonators, qubit capacitor pads. The bottom electrode and the top electrode are separated by a tunnel barrier. Defects in the tunnel barrier can reduce qubit coherence/performance and frequency variation. Variation in the junction size can also cause qubit frequency variation.

The central element - the Josephson junction - may be fabricated on a high-resistivity silicon wafer with a process composed of dry etch and argon milling steps, in accordance with embodiments of the present invention. The process yields highcoherence junctions and high-quality of underlying single layer qubit capacitor structure. Qubit coherence times of more than 70 µs or even more than 100 µs can be obtained.

It is thereby advantageous that the etching and argon milling processing on the entire wafer (e.g. 300mm wafer) is fully compatible to the state-of-the-art manufacturable environment and thus opens a new direction into low variability manufacturable superconducting qubit technology.

A method in accordance with embodiments of the present invention may comprise depositing and patterning a protection layer 210 everywhere except around the Josephson junction (see FIG. 8), wherein depositing and patterning of the protection layer 210 is done after filling the one or more trenches (e.g. after polishing the first layer up to the semiconductor substrate surface) and before removing the native oxide 103B. It is thereby advantageous that metal-air and substrate-air interfaces can be additionally protected during the ion beam-milling and patterning steps. This protection layer 210 is selected such that it can be selectively removed with respect to the first and second metal or barrier oxides. Insulating materials or metals such as Mo can be used.

## Claims

1. A method (100) for making a Josephson junction (200) for a quantum device, the method comprising:
- providing (101) a semiconductor substrate (201),
- providing (102) a bottom electrode (202) embedded in the semiconductor substrate, by forming (102A) one or more trenches (208) in the semiconductor substrate (201), and by filling (102B) the one or more trenches with material comprising a first metal,
- forming (103) a tunnel barrier (205) on the embedded bottom electrode (202) by removing (103B) native oxide from the bottom electrode (202), followed by in situ oxidation (103C) of the bottom electrode (202),
- providing (104) a top electrode (206) which overlaps at least part of the tunnel barrier and bottom electrode,
by providing (104A) a second layer comprising a second metal on the tunnel barrier, and by patterning the second layer such that the Josephson junction is formed by the bottom electrode (202), the tunnel barrier (205), and the top electrode (206).

2. A method (100) according to claim 1, wherein the one or more trenches are formed (102A) such that they have a depth between 50 and 200 nm.

3. A method (100) according to any of the previous claims, the method comprising cleaning the surface of the semiconductor substrate (201) before filling (102B) the one or more trenches (208).

4. A method (100) according to any of the previous claims wherein forming (103) a tunnel barrier further comprises cleaning (103A) the surface of the bottom electrode (202) and of the semiconductor substrate (201) before removing (103B) native oxide from the bottom electrode (202).

5. A method (100) according to any of the previous claims wherein an upper part of the bottom electrode (202) is removed when patterning the second layer.

6. A method (100) according to any of the previous claims wherein the native oxide is removed by ion beam milling.

7. A method (100) according to any of the previous claims wherein the step of providing a semiconductor substrate comprises providing a silicon substrate and/or wherein the provided semiconductor substrate (201) has a resistivity of at least 1kOhm.cm.

8. A method (100) according to any of the previous claims wherein the first metal is Al.

9. A method (100) according to claim 8, wherein filling (102B) the one or more trenches (208), implies filling the one or more trenches with a stack of superconducting materials of which the top material is Al.

10. A method (100) according to any of the previous claims wherein the second metal is Al, or Nb, or alpha-Ta, or NbN, or NbTiN, or TiN, or Mo, or Re.

11. A method (100) according to any of the previous claims, the method further comprising, after patterning the second layer, exposing the semiconductor substrate (201), the bottom electrode (202) and the top electrode (206) to a passivating gas agent.

12. A method (100) according to any of the previous claims, the method (100) further comprising providing a via (220) through the top electrode and the tunnel barrier (205) and filling the via with a metal for shorting a spurious Josephson junction.

13. A method (100) for making a qubit, the method comprising making a Josephson junction in accordance with any of the previous claims and providing a capacitor in parallel with the Josephson junction.

14. A method (100) according to claim 12 wherein the capacitor in parallel with the Josephson junction is made from the material in the trenches such that the bottom electrode comprises two plates which are separated by air and the underlying semiconductor substrate.

15. A method (100) according to any of the previous claims, the method comprising depositing and patterning a protection layer (210) everywhere except around the Josephson junction, wherein depositing and patterning of the protection layer (210) is done after filling the one or more trenches (102B) and before removing the native oxide (103B).
